Europäisches Patentamt

European Patent Office

Office européen des brevets

(19)

(11) Veröffentlichungsnummer: **0 247 615 B1**

(12)     ## EUROPÄISCHE PATENTSCHRIFT

(45) Veröffentlichungstag der Patentschrift: 20.03.91

(51) Int. Cl.5: **H03F 3/60**, H03F 1/02, H04B 1/04

(21) Anmeldenummer: 87107761.6

(22) Anmeldetag: 27.05.87

(54) Sender für kurze elektromagnetische Wellen.

(30) Priorität: 30.05.86 DE 3618099

(43) Veröffentlichungstag der Anmeldung:
02.12.87 Patentblatt 87/49

(45) Bekanntmachung des Hinweises auf die
Patenterteilung:
20.03.91 Patentblatt 91/12

(84) Benannte Vertragsstaaten:
BE DE FR GB IT NL

(56) Entgegenhaltungen:
EP-A- 0 080 771
GB-A- 1 281 972
US-A- 2 686 899
US-A- 4 367 443

PATENT ABSTRACTS OF JAPAN, Band 7, Nr.
170 (E-189)[1315], 27. Juli 1983; & JP-A-58 75
929 (NIPPON DENKI K.K.) 07-05-1983

PATENT ABSTRACTS OF JAPAN, Band 9, Nr.
27 (E-294)[1750], 6. Februar 1985; & JP-A-59
172 816 (NIPPON DENKI K.K.) 29-09-1984

PATENT ABSTRACTS OF JAPAN, Band 7, Nr.

76 (E-167)[1221], 30. März 1983; & JP-A-58
3427 (MITSUBISHI DENKI K.K.) 10-01-1983

(73) Patentinhaber: Siemens Aktiengesellschaft
Wittelsbacherplatz 2
W-8000 München 2(DE)

(72) Erfinder: Fünfgelder, Helmut, Dipl.-Ing. (FH)
Raiffeisenstrasse 68
W-8044 Unterschleissheim(DE)

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

### Technisches Gebiet

Die Erfindung bezieht sich auf einen Sender für kurze elektromagnetische Wellen, insbesondere Kurzwellensender, dessen Senderendstufe mehrere Leistungsendstufen umfaßt, bei denen das zu verstärkende, von einer Leistungsvorstufe abgegebene Signal sämtlichen Leistungsendstufen eingangsseitig jeweils mit gleicher Steuerleistung über einen Signalaufteiler zugeführt ist, und bei dem die Ausgänge der Leistungsendstufen über ein Gabelschaltungen und Übertrager aufweisendes Netzwerk zu einem Summenausgang vereinigt sind, der die Summe der phasenrichtig addierten Signalausgangsleistungen sämtlicher Leistungsendstufen an eine Summenausgangsleitung abgibt.

### Zugrundeliegender Stand der Technik

Voll transistorisierte Kurzwellensender für höhere Leistungen in der Größenordnung von 100 W bis 1 kW machen wegen der begrenzten Ausgangsleistung von Hochfrequenzleistungstransistoren von mehreren Leistungsendstufen Gebrauch, die ausgangsseitig in geeigneter Weise zum eigentlichen Senderausgang zusammengefaßt werden müssen. Kurzwellensender dieser Art sind beispielsweise durch die Literaturstellen DE-C-21 13 445 und DE-A-33 38 878 bekannt. Die eingangsseitige Aufteilung der Signalenergie auf die Eingänge der verschiedenen Leistungsendstufen sowie die ausgangsseitige Zusammenfassung der Leistungsendstufen zu einem gemeinsamen Summenausgang kann, wie die Literaturstelle Francis Elektronik-Fachbuch, Gerhard E. Gerzelka: Funkfernverkehrssysteme in Design und Schaltungstechnik" Franzis-Verlag GmbH, München, 1982, Seiten 242 bis 251 auf verschiedene Weise verwirklicht werden. Regelmäßig wird hierbei jedoch von Gabelschaltungen und Übertragern Gebrauch gemacht, bei denen die Gabelübertrager mit hoch belastbaren Balance-Widerständen versehen sind, die bei Ausfall einer Leistungsendstufe die dann auftretende Unsymmetrie-Leistung absorbieren.

Eine Reduzierung der Nenn-Ausgangsleistung ist bei solchen Sendern ausschließlich durch geringere Ansteuerung der Leistungsendstufen, d.h. durch ein Stellglied in der Kleinsignalebene möglich. Die Gleichstrom-Eingangsleistung für die Leistungsendstufen wird dabei trotz der wesentlich geringeren HF-Ausgangsleistung nicht nennenswert reduziert. Dies stellt einen erheblichen Nachteil insbesondere dann dar, wenn solche Kurzwellensender für den mobilen Einsatz vorgesehen sind und dabei ein möglichst sparsamer Umgang mit der verfügbaren Betriebsenergie gefordert werden muß. Aus Patent Abstracts of Japan, Band 7, Nr. 170 (E-189) [13 15], 27 Juli 1983 (& JP-A-58 75 929) ist er bekannt, zur Erziehung unterschiedlich hoher Ausgangsleistungen über Abzweigschaltungen angeschlossene Verstärker aus dem Signalweg zu-und abzuschalten. Eine Speiseleistungsreduzierung ist dabei nicht vorgehesen.

Aus Patent Abstracts of Japan, Band 7, Nr. 76 (E-167) [1221], 30 März 1983 (& JP-A-58 3427) geht der Hinweis hervor, einen in einem Modulationszweig liegenden Verstärker nur dann zuzuschalten, wenn ein Modulationssignal vorliegt, wodurch Speiseleistung eingespart wird.

### Offenbarung der Erfindung

Der Erfindung liegt die Aufgabe zugrunde, für einen Sender der einleitend beschriebenen Art eine weitere Lösung anzugeben, die bei Reduzierung der Nenn-Ausgangsleistung in gleicher Weise eine entsprechende Reduzierung der Gleichstrom-Eingangsleistung der Leistungsendstufen ermöglicht.

Diese Aufgabe wird gemäß der Erfindung durch die im Patentanspruch 1 angegebenen Merkmale gelöst.

Der Erfindung liegt die wesentliche Erkenntnis zugrunde, daß bei einer Reduzierung der Nenn-Ausgangsleistung eines von mehreren Leistungsendstufen Gebrauch machenden Senders diese Reduzierung auch in der Weise vorgenommen werden kann, daß die abzugebende Hochfrequenzleistung auf wenigstens eine voll auszusteuernde Leistungsendstufe beschränkt wird, so daß die übrigen Leistungsendstufen abgeschaltet und damit eine entsprechende Reduzierung der hohen Gleichstrom-Eingangsleistung herbeigeführt wird. Ein solcher Betrieb ist möglich, wenn, wie vorgeschlagen, dafür gesorgt wird, den Ausgang einer Leistungsendstufe unmittelbar auf den Senderausgang durchzuschalten.

Vorteilhafte Ausgestaltungen der Erfindung sind in den weiteren Patentansprüchen 2 und 3 angegeben.

### Kurze Beschreibung der Zeichnung

In der Zeichnung bedeuten die der näheren Erläuterung der Erfindung dienenden Figuren

Fig. 1    das Blockschaltbild der Ausgangsseite eines von mehreren Leistungsendstufen Gebrauch machenden Senders,

Fig. 2    das Schaltbild eines die Leistungsendstufen ausgangsseitig zusammenfassenden Netzwerks nach der Erfindung,

Fig. 3 ein erstes Frequenz-Gleichstromleistungsdiagramm,

Fig. 4 eine Variante des Netzwerks nach Fig.
2,

Fig. 5 ein weiteres Frequenz-Gleichstromleistungsdiagramm,

Fig. 6 ein weiteres Frequenz-Gleichstromleistungsdiagramm.

Bester Weg zur Ausführung der Erfindung

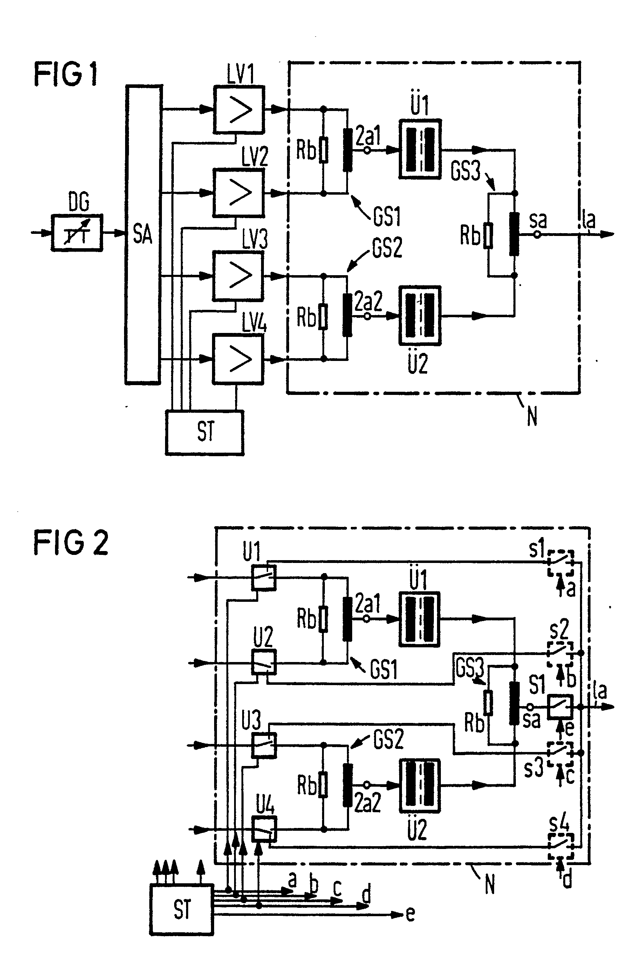

Das Blockschaltbild des Endverstärkers nach Fig. 1 weist im wesentlichen vier Leistungsendstufen LV1, LV2, LV3 und LV4 auf. Die ankommende Signalenergie von der Leistungsvorstufe wird über ein einstellbares Dämpfungsglied DG und einen Signalaufteiler SA gleichmäßig und phasengleich auf die vier Eingänge der Leistungsendstufen aufgeteilt. Ausgangsseitig sind die vier Leistungsendstufen LV1, LV2, LV3 und LV4 mit dem Netzwerk N verbunden, über das hinweg die vier Ausgänge der Leistungsendstufen zum Summenausgang sa zusammengefaßt werden, der die Summe der phasenrichtig addierten Signalausgangsleistung sämtlicher Leistungsendstufen an eine Summenausgangsleitung la abgibt. Zur Steuerung, insbesondere zum Ein- und Ausschalten der Betriebsgleichspannungsversorgung sind die vier Leistungsendstufen LV1, LV2, LV3 und LV4 jeweils über eine Leitung mit der Steuereinrichtung ST verbunden.

Das Netzwerk N weist auf der Eingangsseite die Gabelschaltungen GS1 und GS2 auf, von denen die Gabelschaltung GS1 die Ausgänge der Leistungsendstufen LV1 und LV2 zu einem gemeinsamen Ausgang 2a1 und die Gabelschaltung GS2 die Ausgänge der Leistungsendstufen LV3 und LV4 zum gemeinsamen Ausgang 2a2 zusammenfassen. Die beiden Eingänge der Gabelschaltung GS1 und GS2, die jeweils mit den Ausgängen der zugehörigen Leistungsendstufen verbunden sind, sind ferner jeweils durch den Balance-Widerstand Rb miteinander verbunden. Den Gabelschaltungen GS1 und GS2 ist in Signalflußrichtung jeweils ein Übertrager Ü1 bzw. Ü2 nachgeschaltet, über die hinweg die beiden gemeinsamen Ausgänge 2a1 und 2a2 der Gabelschaltungen GS1 und GS2 über die weitere Gabelschaltung GS3 mit dem Balance-Widerstand Rb zum sämtlichen Leistungsendstufen LV1, LV2, LV3 und LV4 gemeinsamen Summenausgang sa vereinigt sind. Die Übertrager Ü1 und Ü2 weisen das Übersetzungsverhältnis 1 : 4 auf, so daß der Innenwiderstand des Senders am Summenausgang sa, beispielsweise 5Ω, den gleichen Wert aufweist wie der Innenwiderstand des Ausgangs einer Leistungsendstufe LV1, LV2, LV3 und LV4.

Durch entsprechende Einstellung des Dämpfungsgliedes DG auf der Eingangsseite des Signalaufteilers SA kann die Nenn-Ausgangsleistung des Senders, die hierbei beispielsweise bei einer Nenn-Ausgangsleistung der Leistungsendstufen LV1, LV2, LV3 und LV4 von jeweils 250 W 1000 W beträgt, in weiten Grenzen herabgesetzt werden. Wie bereits erwähnt worden ist, wird hierdurch jedoch die den Leistungsendstufen jeweils zuzuführende Gleichstromleistung kaum reduziert, so daß der Wirkungsgrad des Senders umso schlechter wird, je größer die Reduzierung der Nenn-Ausgangsleistung eingestellt wird.

Durch die erfindungsgemäße Ergänzung des Netzwerks N, wie sie in Fig. 2 in einem ersten Ausführungsbeispiel dargestellt ist, läßt sich ein Betrieb bei reduzierter Nenn-Ausgangsleistung verwirklichen, bei dem dann auch eine der Reduktion entsprechende Verminderung der benötigten Gleichstromleistung erreicht wird.

Das Netzwerk N nach Fig. 2 unterscheidet sich vom Netzwerk N nach Fig. 1 dadurch, daß in den Zuführungen von den Ausgängen der Leistungsendstufen LV1, LV2, LV3 und LV4 zu den Eingängen der Gabelschaltung GS1 und GS2 Umschalter U1, U2, U3 und U4 vorgesehen sind. Mit Hilfe dieser Umschalter können die Ausgänge der Leistungsendstufen wahlweise über die Gabelschaltungen oder aber unmittelbar mit der Summenausgangsleitung la verbunden werden. Gleichzeitig wird bei einer solchen Direktschaltung der Summenausgang sa auf der Ausgangsseite der Gabelschaltung GS3 über den weiteren Schalter S1 von der Summenausgangsleitung la abgeschaltet. Auf diese Weise ist es also möglich, bei einer Reduzierung der Nenn-Ausgangsleistung des Senders, und zwar von 1000 W auf 250 W lediglich eine der vier Leistungsendstufen LV1 mit ihrer Nenn-Ausgangsleistung zu betreiben und die übrigen drei Leistungsendstufen abzuschalten. Die Steuerung der Umschalter U1, U2, U3 und U4 sowie des Schalters S1 erfolgt durch die um diese Schaltfunktion erweiterte Steuereinrichtung ST.

Wie Fig. 2 noch ferner erkennen läßt, sind auf seiten der Summenausgangsleitung la in der Verbindungsleitung der Umschalter U1, U2, U3 und U4 noch in unterbrochener Linie jeweils ein Schalter s1, s2, s3 und s4 angegeben, die von der Steuereinrichtung ST jeweils über eine Steuerleitung a, b, c und d ansteuerbar sind. Eine weitere Steuerleitung e der Steuereinrichtung ST dient der Ansteuerung des Schalters S1. Die Schalter s1, s2, s3 und s4 werden zweckmäßig zur hochfrequenzmäßigen Entkopplung vorgesehen, wenn es sich bei den Verbindungsleitungen zwischen den Umschaltern U1, U2, U3 und U4 zu der Summenausgangsleitung la um längere Leitungsabschnitte handelt.

Die unmittelbare Anschaltung einer der Leistungsendstufen LV1, LV2, LV3 und LV4 an die Summenausgangsleitung la gibt auch die Möglichkeit, bei Ausfall oder Störung einer Leistungsendstufe zu einem Betrieb mit reduzierter Nenn-Ausgangsleistung überzugehen und auf diese Weise die ansonsten bewirkte Schieflage in der Leistungszusammenfassung und damit die Verschlechterung der Linearitätseigenschaften des Senders zu umgehen.

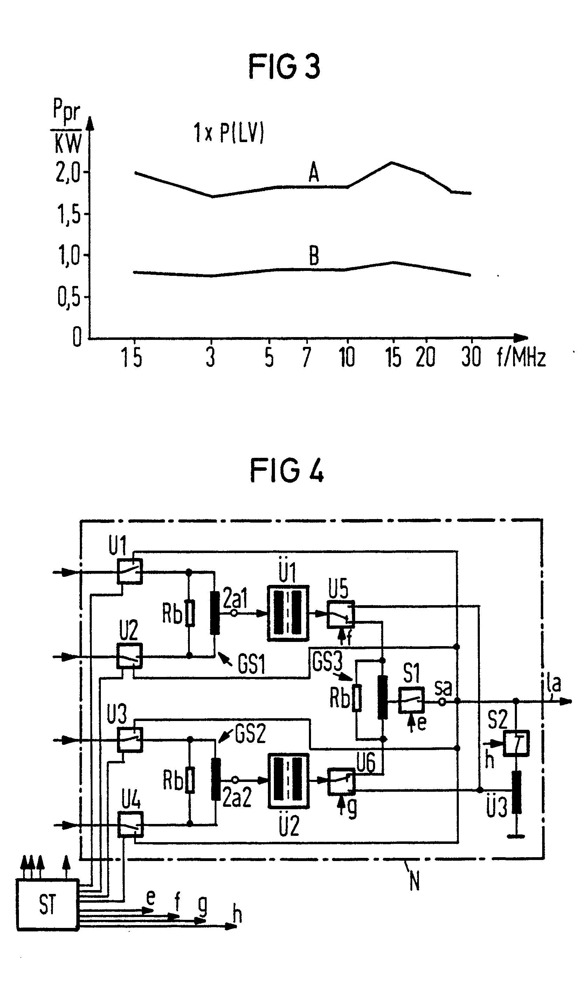

Das Diagramm der Fig. 3, bei dem die Gleichstrom-Eingangsleistung Ppr in kW über der Frequenz in MHz aufgetragen ist, bedeuten die Linie A der Verlauf der Gleichstrom-Eingangsleistung Ppr bei reduzierter Nenn-Ausgangsleistung auf die Nenn-Ausgangsleistung einer der vier Leistungsendstufen LV1, LV2, LV3 und LV4 (1 × P-(LV) durch entsprechende Einstellung des Dämpfungsgliedes DG nach Fig. 1, während die Kurve B den entsprechenden Verlauf bei Durchschaltung des Ausgangs einer Leistungsendstufe auf die Summenausgangsleitung la bei gleichzeitiger Abschaltung der übrigen Leistungsendstufen wiedergibt. Wie Fig. 3 erkennen läßt, ergibt sich durch die erfindungsgemäße Maßnahme eine Reduzierung der Eingangsgleichstromleistung Ppr um praktisch den Faktor zwei.

Die Variante des Netzwerks nach Fig. 2 in Fig. 4 trägt dem Umstand Rechnung, daß es mitunter auch wünschenswert sein kann, anstelle einer Reduzierung der Nenn-Ausgangsleistung des Senders auf die Nenn-Ausgangsleistung einer der Leistungsendstufen eine solche Reduzierung auf die Nenn-Ausgangsleistung von zwei solcher Leistungsendstufen zu ermöglichen. Bei dem gewählten Ausführungsbeispiel mit vier Leistungsendstufen ist dies dadurch herbeigeführt, daß zusätzlich jeder der gemeinsamen Ausgänge 2a1 und 2a2 der Gabelschaltungen GS1 und GS2 über den jeweiligen Übertrager Ü1 und Ü2 hinweg durch einen weiteren Umschalter U5 bzw. U6 wahlweise über den Übertrager Ü3 und den Schalter S2 hinweg an die Summenausgangsleitung la anschaltbar sind. Der Übertrager Ü3 dient hier wiederum lediglich der Transformation des Innenwiderstandes des Senderausgangs im Falle dieser Umschaltung an den vorgegebenen Wert im Bereich der Summenausgangsleitung la. Die Umschalter U5 und U6 sowie der Schalter S2 sind mit der Steuereinrichtung ST jeweils über eine Steuerleitung f, g bzw. h verbunden.

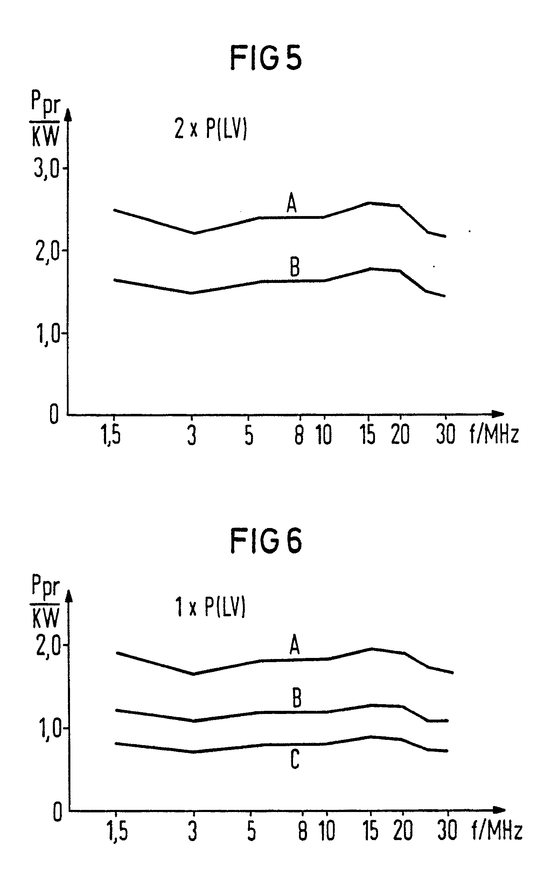

Das Fig. 3 entsprechende Diagramm in Fig. 5 bezieht sich auf eine reduzierte Nenn-Ausgangsleistung auf die Nenn-Ausgangsleistung von zwei Leistungsendstufen (2 × P(LV), also entsprechend Fig. 4 auf die Leistungsendstufen LV1 und LV2 bzw. auf die Leistungsendstufen LV3 und LV4. Auch hier läßt sich gegenüber einer reduzierten Nenn-Ausgangsleistung über eine entsprechende Einstellung des Dämpfungsgliedes DG nach Fig. 1 (Kurve A) eine wesentliche Einsparung an Gleichstrom-Eingangsleistung Ppr erzielen, wenn anstelle der Reduzierung über das Dämpfungsglied DG eine Umschaltung über einen der Umschalter U5 und U6 bei gleichzeitiger Betätigung der Schalter S1 und S2 lediglich zwei Leistungsendstufen mit ihrer vollen Nenn-Ausgangsleistung betrieben werden und die übrigen Leistungsendstufen abgeschaltet werden (Kurve B).

Das den Figuren 3 und 5 entsprechende Diagramm der Fig. 6 bezieht sich wiederum auf eine reduzierte Nenn-Ausgangsleistung entsprechend einer Nenn-Ausgangsleistung einer Leistungsendstufe (1 × P(LV), wobei die Kurve A wiederum den Verlauf der Gleichstrom-Eingangsleistung Ppr über der Frequenz f bei Betrieb sämtlicher Leistungsendstufen LV1, LV2, LV3 und LV4 mit reduzierter Signaleingangsleistung über das Dämpfungsglied DG wiedergibt. Die Kurve B zeigt den entsprechenden Verlauf bei zwei in Betrieb befindlichen Leistungsendstufen und Abschaltung der übrigen Leistungsendstufen. Die Kurve C schließlich zeigt den entsprechenden Verlauf bei Betrieb von lediglich einer Leistungsendstufe mit ihrer Nenn-Ausgangsleistung bei unmittelbarer Durchschaltung auf die Summenausgangsleitung la und Abschaltung der übrigen Leistungsendstufen.

## Gewerbliche Verwertbarkeit

Sender, insbesondere Kurzwellensender mit Anpassung der Gleichstrom-Eingangsleistung des aus mehreren Leistungsendstufen bestehenden Endverstärkers an eine reduzierte Nenn-Ausgangsleistung sind besonders für den taktischen mobilen Einsatz geeignet.

## Ansprüche

1. Sender für kurze elektromagnetische Wellen, insbesondere Kurzwellensender, dessen Senderendstufe mehrere Leistungsendstufen umfaßt, bei dem das zu verstärkende, von einer Leistungsvorstufe abgegebene Signal sämtlichen Leistungsendstufen eingangsseitig jeweils mit gleicher Steuerleistung über einen Signalaufteiler zugeführt ist und bei dem die Ausgänge der Leistungsendstufen über ein Gabelschaltungen und Übertrager aufweisendes Netzwerk zu einem Summenausgang vereinigt sind, der die Summe der phasenrichtig addierten Signalausgangsleistungen sämtlicher Leistungsendstufen an eine Summenausgangsleitung abgibt, **dadurch gekennzeichnet,** daß das Netzwerk (N) eingangsseitig für jeden der hieran ausgangsseitig angeschlossenen Leistungsendstufen (LV1, LV2, ... LV4) einen Umschalter (U1, U2, ... U4) aufweist, mit dessen Hilfe der Ausgang einer Leistungsendstufe wahlweise unmittelbar mit der Summenausgangsleitung (la) verbindbar ist, daß ferner die Summenausgangsleitung (la) an den Summenausgang (sa) über einen Schalter (S1) anschaltbar ist und daß beim unmittelbaren Anschalten einer Leistungsendstufe an die Summenausgangsleitung gleichzeitig mit dem Betätigen des betreffenden Umschalters (U1, U2, ... U4) die Betriebsspannungsversorgung der übrigen Leistungsendstufen abgeschaltet und der Schalter (S1) geöffnet wird.

2. Sender nach Anspruch 1, bei dem das Netzwerk (N) zunächst jeweils die Ausgänge zweier Leistungsendstufen (LV1/LV2, LV3/LV4) zu einem gemeinsamen Ausgang (2a1, 2a2) zusammenfaßt,
**dadurch gekennzeichnet,** daß jeder gemeinsame (2a1, 2a2) Ausgang mittels eines Umschalters (U5, U6) über einen Übertrager (Ü3) und einen Schalter (S2) hinweg an die Summenausgangsleitung (la) anschaltbar ist und daß beim Anschalten eines solchen gemeinsamen Ausgangs eines Paares von Leistungsendstufen (LV1/LV2, LV3/LV4) an die Summenausgangsleitung gleichzeitig mit dem Betätigen des betreffenden Umschalters die Betriebsspannungsversorgung des anderen Paares von Leistungsendstufen abgeschaltet, der Schalter (S1) im Verbindungsweg zwischen dem Summenausgang (sa) und Summenausgangsleitung (la) geöffnet und der Schalter (S2) im Verbindungsweg zwischen dem Übertrager (Ü3) und der Summenausgangsleitung geschlossen wird.

3. Sender nach einem der vorhergehenden Ansprüche,
**dadurch gekennzeichnet,** daß zur besseren hochfrequenzmäßigen Entkopplung im Verbindungsweg zwischen jeweils einem Umschalter (U1, U2, ... U4) und der Summenausgangsleitung (la) auf seiten der Summenausausgangsleitung ein weiterer, gemeinsam mit dem zugehörigen Umschalter betätigter Schalter (s1, s2, ... s3, s4) vorgesehen ist.

## Claims

1. Transmitter for short electromagnetic waves, preferably shortwave transmitter, the transmitter final stage of which comprises a plurality of power output stages, in which the signal to be amplified, emitted by a preamplifier stage, is fed via a signal divider to all the power output stages on the input side in each case with the same control power and in which the outputs of the power output stages are combined via a network having hybrid circuits and repeaters to form a group output which transmits the sum of the signal output powers, added in phase, of all the power output stages to a group output line, characterized in that the network (N) has a change-over switch (U1, U2, ... U4) on the input side for each of the power output stages (LV1, LV2, ... LV4) connected to said network on the output side, with the aid of which change-over switch the output of a power output stage can be optionally connected directly to the group output line (1a), in that, furthermore, the group output line (1a) can be connected to the group output (sa) via a switch (S1), and in that when a power output stage is directly connected to the group output line simultaneously with the actuation of the respective change-over switch (U1, U2, ... U4), the operating voltage supply of the other power output stages is switched off and the switch (S1) is opened.

2. Transmitter according to Claim 1, in which the network (N) first combines in each case the outputs of two power output stages (LV1/LV2, LV3/LV4) to form a common output (2a1, 2a2), characterized in that each common (2a1, 2a2) output can be connected via a repeater (Ü3) and a switch (S2) to the group output line (1a) by means of a change-over switch (U5, U6), and in that, when such a common output of a pair of power output stages (LV1/LV2, LV3/LV4) is connected to the group output line simultaneously with the actuation of the respective change-over switch, the operating voltage supply of the other pair of power output stages is switched off, the switch (S1) in the connecting path between the group output (sa) and group output line (1a) is opened and the switch (S2) in the connecting path between the repeater (Ü3) and the group output line is closed.

3. Transmitter according to one of the preceding claims, characterized in that, for the purpose of achieving better high-frequency isolation in the connecting path between in each case a change-over switch (U1, U2, ... U4) and the group output line (1a), a further switch (s1, s2, ... s3, s4) which can be actuated together with the associated change-over switch, is provided on the group output line side.

## Revendications

1. Emetteur pour ondes électromagnétiques courtes, notamment émetteur à ondes courtes, dont l'étage final comprend plusieurs étages finals de puissance, et dans lequel le signal devant être amplifié et délivré par un étage amont de puissance, est envoyé à tous les étages finals de puissance, situés du côté entrée et possédant respectivement la même puissance de commande, par l'intermédiaire d'un répartiteur du signal, et dans lequel les sorties des étages finals de puissance sont réunies par l'intermédiaire d'un réseau comportant des termineurs et des transformateurs, à une sortie du signal somme, qui envoie la somme des puissances de sortie du signal, additionnées d'une manière correcte en phase, de tous les étages finals de puissance à une ligne de sortie du signal somme,
caractérisé par le fait que le réseau (N) comporte, sur le côté entrée, pour chacun des étages finals de puissance (LV1, LV2...LV4), raccordés au côté sortie de ce réseau, un commutateur (U1,U2...U4), à l'aide duquel la sortie d'un étage final de puissance peut être reliée au choix directement à la ligne (1a) de sortie du signal somme, qu'en outre la ligne (1a) de sortie du signal somme peut être raccordée à la sortie (sa) du signal somme par l'intermédiaire d'un interrupteur (S1) et que, lors du raccordement direct d'un étage final de puissance à la ligne de sortie du signal somme, l'alimentation des autres étages finals de puissance avec la tension de service est interrompue simultanément lors de l'actionnement du commutateur (U1, U2... U4) considéré et l'interrupteur (S1) est ouvert.

2. Emetteur suivant la revendication 1, dans lequel le réseau (N) réunit tout d'abord les sorties des deux étages finals de puissance (LV1,/LV2,LV3/LV4) à une sortie commune (2al, 2a2), caractérisé par le fait que chaque sortie commune (2a1,2a2) peut être raccordée à la ligne (1a) de sortie du signal somme au moyen d'un commutateur (U5,06), par l'intermédiaire d'un transformateur (Ü3) et d'un interrupteur (S2), et que lors du raccordement d'une telle sortie commune d'un couple d'étages finals de puissance (LV1/LV2,LV2/LV4) à la ligne de sortie du signal somme, l'alimentation de l'autre couple d'étages finals de puissance avec la tension de service est interrompue simultanément lors de l'actionnement du commutateur considéré, l'interrupteur (S1) situé dans le trajet de liaison entre la sortie (sa) du signal somme et la ligne (1a) de sortie du signal somme est ouvert et l'interrupteur (S2) situé dans la voie de liaison entre le transformateur (Ü3) et la ligne de sortie du signal somme est fermé.

3. Emetteur suivant l'une des revendications précédentes, caractérisé par le fait que pour avoir un meilleur découplage du point de vue des hautes fréquences, un autre interrupteur (s1,s2...s3,s4) actionné en commun par le commutateur associé est prévu dans la voie de liaison entre respectivement un commutateur (U1,U2,...U4) et la ligne (1a) de sortie du signal somme, du côté de cette ligne de sortie.

## FIG 1

## FIG 2

## FIG 3

$\dfrac{P_{pr}}{KW}$

$1 \times P(LV)$

A

B

2,0

1,5

1,0

0,5

0

15    3    5    7    10    15   20    30   f/MHz

## FIG 4

U1  U2  U3  U4

Ü1  Ü2  Ü3

U5  U6

Rb  2a1  2a2

GS1  GS2  GS3

S1  S2  sa  Ia

e  f  g  h

N

ST

e  f  g  h

# FIG 5

# FIG 6